# EUROPÄISCHE PATENTANMELDUNG

(11) **EP 1 067 390 A1**
(43) Veröffentlichungstag der Anmeldung: **10.01.2001**
(21) Anmeldenummer: 00112731.5
(22) Anmeldetag: 16.06.2000
(51) Int. Cl.: G01R 1/04

(54) **Mobiles elektrisches Messgerät mit abnehmbarer Bedienungseinheit**

(30) Priorität: 08.07.1999 DE 19931888
(71) Anmelder: Wavetek Wandel Goltermann Eningen GmbH & Co., 72800 Eningen u. A. (DE)
(72) Erfinder: Brandt, Hartmut, 72581 Dettingen/Ems (DE); Kaschte, Ernst, 72800 Eningen u.A. (DE); Mathä, Johann, 72631 Aichtal (DE); Schubert, Rolf, 72800 Eningen u.A. (DE); Sieber, Roland, 72469 Messstetten (DE); Staiger, Reinhardt, 72805 Lichtenstein (DE); Winterhalter ,Rudi, 72770 Reutlingen (DE)
(74) Vertreter: Klocke, Peter, Dipl.-Ing.

(57) **Zusammenfassung**

Mobiles elektrisches Messgerät (1) mit einem Gehäusekasten (2) zur Aufnahme im Inneren der für den Betrieb des Messgeräts erforderlichen Gerätekomponenten und mit einer Benutzerschnittstelle (3) zur vollständigen Bedienung des Messgeräts und zur Ablesung der Messergebnisse, wobei die Benutzerschnittstelle als vom Gehäusekasten separate Bedienungseinheit ausgebildet ist und das Messgerät entfernt vom Gehäusekasten bedienbar ist. Die Bedienungseinheit ist als Flachmodul mit Flachbildschirm ausgebildet und kann gleichzeitig als Schutzdeckel bei entsprechender Anbringung (Rückseite nach außen) an dem Gehäusekasten verwendet werden. Sie übernimmt damit die Schutzfunktion für die Bedienelemente.

## Beschreibung

Die vorliegende Erfindung betrifft ein mobiles elektrisches Messgerät mit einem Gehäusekasten zur Aufnahme im Inneren der für den Betrieb des Messgerätes erforderlichen Gerätekomponenten und mit einer Benutzerschnittstelle zur Bedienung des Messgerätes.

Elektrische Messgeräte, insbesondere größere Messgeräte, wie sie für die Überwachung und Messung von Telekommunikationssignalen erforderlich sind, weisen einen Gehäusekasten mit einer integrierten Benutzerschnittstelle auf, die üblicherweise Eingabeelemente wie eine alphanumerische Tastatur, Funktionstasten, Schalter, Trackball, Touchpad, Mikrofon usw. sowie Ausgabeelemente wie numerische und alphanumerische Anzeigen, zeichenorientierte oder grafische Bildschirme, Lautsprecher, usw. umfasst, um mit dem Messgerät Messungen an Ort und Stelle durchführen zu können. Häufig weisen diese Messgeräte ein relativ hohes Gewicht auf und müssen für die Messung auch an schlecht zugänglichen Stellen platziert werden. Für die das Messgerät bedienende Person ist dann die Handhabung beispielsweise in Schächten, auf hoch gelegenen Messorten oder dergleichen schwierig und unangenehm.

Es sind Messgeräte mit integrierter Benutzerschnittstelle oder ganz ohne Benutzerschnittstelle bekannt, die über einen Datenkanal ferngesteuert werden können, so dass die Gerätebedienung vom Messort entfernt erfolgen kann. Ferngesteuerte Geräte sind jedoch im allgemeinen am Messort fest eingebaut und für den mobilen Einsatz ungeeignet.

So ist aus der US 5,794,164 ein Fahrzeugcomputersystem bekannt, das eine stationäre Basiseinheit in dem Fahrzeug aufweist, in die von einer Stirnseite verschiedene Speichermedien eingeschoben werden können. Vor dieser Stirnseite befindet sich eine abnehmbare Frontplatte mit Bedienelementen, über die der Computer bedient werden kann. Zusätzlich können über ein LCD-Display an der Frontplatte visuelle Daten ausgegeben werden. Der Computer ist auch noch mit einem externen und entfernt angeordneten Monitor verbindbar, um auf diesem Fahrzeug Daten verschiedener Fahrzeuge sichtbar zu machen.

Aus der US 5,793,621 ist eine nicht unterbrechbare Spannungsversorgung mit einem abnehmbaren Anzeiger und Steuermodul offenbart. Das Modul befindet sich in einer Ausnehmung an einer Stirnseite und weist eine Anzeigeeinrichtung auf, mit dem er die Funktionsfähigkeit der Spannungsversorgung überwacht werden kann.

In der US 3,757,218 ist ein elektrisches Testinstrument beschrieben, das einen über eine Leitung mit dem Testinstrument verbundenen Messkopf aufweist, der an seinem einen Ende eine Spitze und am entgegengesetzten Ende einen kleinen Bildschirm aufweist, um an diesem die gemessenen Spannungs- oder Widerstandswerte ablesen zu können. Der Messkopf selbst wird in einem Schacht in dem Gehäuse des Testinstruments gelagert. Eine Bedienung des Messgeräts über den Messkopf ist nicht möglich.

Aus dem vorstehend beschriebenen Stand der Technik ist kein Messgerät bekannt, das geeignet ist, Messungen durchzuführen, wobei die ausschließliche Bedienung sowie die Anzeige der Messergebnisse und auch möglicher Messauswertungen entfernt von dem Messgerät erfolgt.

Der vorliegenden Erfindung liegt daher die Aufgabe zugrunde, ein in seiner Handhabung verbessertes elektrisches Messgerät vorzuschlagen, bei dem die Benutzerschnittstelle vom eigentlichen Messgerät getrennt werden kann und trotzdem ein mobiler Einsatz möglich ist.

Diese Aufgabe wird erfindungsgemäß mit den Merkmalen des Anspruchs 1 gelöst. Weitere vorteilhafte Ausgestaltungen sind den Unteransprüche zu entnehmen.

Danach weist das erfindungsgemäß ausgestaltete mobile elektrische Messgerät eine Benutzerschnittstelle auf, die als vom Gehäusekasten separate Bedienungseinheit ausgebildet ist und eine Benutzung des Messgeräts entfernt von dem Gehäusekasten ermöglicht. Dabei umfasst die Benutzerschnittstelle alle Elemente, die zum Ablesen der Messergebnisse und zur Gerätebedienung notwendig sind. Die Bedienungseinheit kann einen Bildschirm, der sowohl der Gerätesteuerung wie auch der Messergebnisdarstellung dient (Touch-Screen), oder einen Bildschirm und alle Bedienelemente (alphanumerische Tastatur, Funktionstasten) oder eine Punktmatrixanzeige und alle Bedienelemente (alphanumerische Tastatur, Funktionstasten) umfassen. Vorzugsweise ist die Bedienungseinheit als ein Flachmodul mit Flachbildschirm ausgebildet, das auf einer Flachseite eine großflächige Anzeige mit integrierten oder separaten Bedienelementen aufweist. Eine derart ausgestaltete Benutzerschnittstelle, bei der die Verbindung zum Gehäusekasten per Datenübertragung mittels Infrarotstrahlung, Funksignale, Lichtwellenleiter oder metallische Kabel erfolgen kann, hat den großen Vorteil, dass das Messgerät nahe an den zu messenden Einrichtungen untergebracht werden kann, wobei das Gewicht des Messgeräts keine so große Rolle mehr spielt, und zusätzlich der Bedienungskomfort erheblich verbessert ist, da die Bedienungsperson die Bedienungseinheit entfernt von dem Messgerät beispielsweise ohne Störung durch das Sonnenlicht, einer beengten räumlichen Umgebung am Messplatz, Erreichbarkeit des Messplatzes nur mittels einer Leiter, oder dergleichen, die Messung durchführen kann.

Gemäß einer weiteren vorteilhaften Ausgestaltung weist der Gehäusekasten Halteelemente zum Fixieren der Bedienungseinheit am Gehäusekasten auf. Dadurch kann die Benutzerschnittstelle, sofern es für den Anwendungsfall gerade nützlich ist, in gewohnter Weise direkt an dem Gehäusekasten bedient werden. Für den Transport kann die Bedienungseinheit, gemäß einer weiteren vorteilhaften Ausgestaltung mit der Vorderseite (Bedienungsseite) dem Gehäusekasten zugewandt an diesem fixiert werden. Dies erspart den üblicherweise bei Messgeräten dieser Art vorhandenen Schutzdeckel für die. Benutzerschnittstelle.

Damit die Bedienungseinheit, insbesondere beim Transport des Messgerätes, geschützt und beim Transport nicht stört, ist sie in einer Ausnehmung in dem Gehäusekasten integriert und überragt vorteilhafterweise mit ihrer Außenkontur nicht die Außenkontur des Gehäusekastens. Diese Ausnehmung kann auch als Gehäuseschacht ausgebildet sein, wobei die Anordnung der Bedienungseinheit als Gehäusedeckel geringere Abmessungen erlaubt.

Nachfolgend wird die Erfindung anhand eines Ausführungsbeispiels näher dargestellt. Es stellen dar:
Figur 1: das Messgerät mit Gehäusekasten und entfernt vom Gehäusekasten befindlicher Benutzerschnittstelle;
Figur 2: das Messgerät mit am Gehäusekasten fixierter Benutzerschnittstelle für die Bedienung;
Figur 3: das Messgerät mit am Gehäusekasten fixierter Benutzerschnittstelle in Transportstellung in der Funktion als Schutzdeckel und
Figur 4: einen Querschnitt durch den Gehäusekasten und die an dem Gehäusekasten fixierte Benutzerschnittstelle.

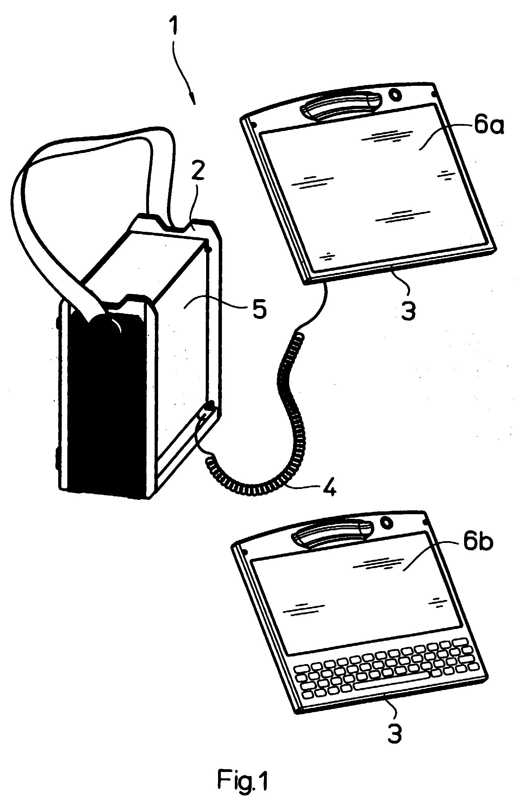

Figur 1 zeigt das Messgerät 1 mit dem Gehäusekasten 2 und der Benutzerschnittstelle 3, die in dem Ausführungsbeispiel über ein Kabel 4 miteinander verbunden sind. Der Gehäusekasten 2 weist eine Ausnehmung 5 auf, in der die Benutzerschnittstelle 3 fixierbar ist. In dem Ausführungsbeispiel ist die Benutzerschnittstelle 3 in einem flachen Gehäuse mit einem Touch-Screen 6a versehen, der sowohl die vollständige Bedienung des Messgeräts ermöglicht, als auch die Messergebnisse in der messgerätspezifischen Art und Weise anzeigt. Möglich ist auch, die Bedienelemente (z. B. eine Tastatur) und den Bildschirm zur Ergebnisanzeige voneinander zu trennen, wie es in 6b angedeutet ist.

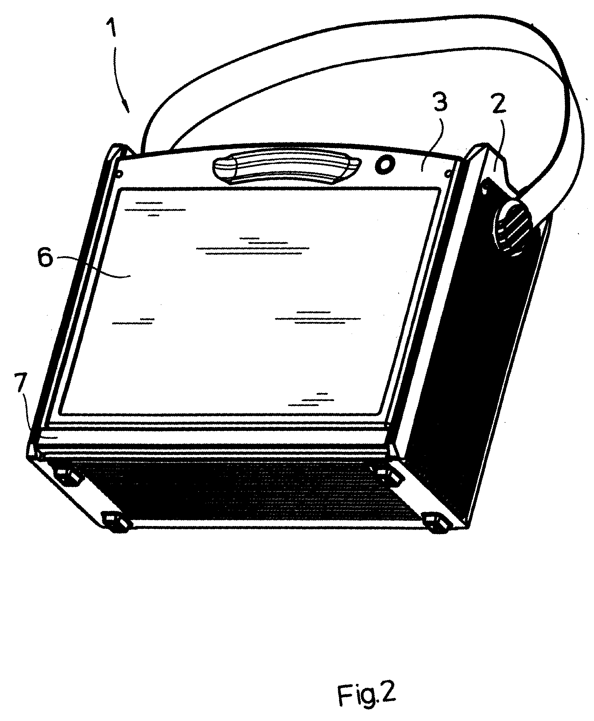

Figur 2 zeigt das Messgerät 1 mit der Benutzerschnittstelle 3, die in der Ausnehmung 5 des Gehäusekastens 2 so fixiert ist, dass eine Bedienung des Messgeräts über die Bedienoberfläche 6a oder 6b möglich ist. Das Kabel 4 kann dabei in einem speziellen Fach untergebracht sein, dass sich in der Blende 7 verbirgt.

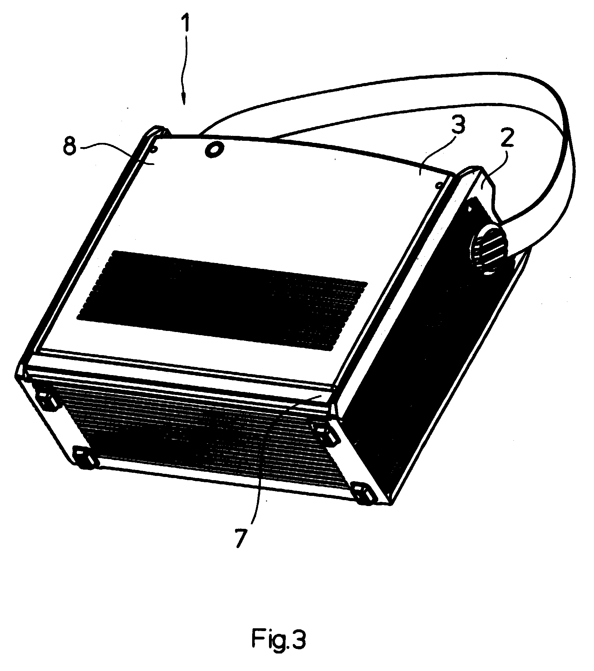

Figur 3 entspricht der Figur 2 mit dem Unterschied, dass die Benutzerschnittstelle 3 so fixiert ist, dass die Rückseite 8 nach außen sichtbar und damit der Bedienoberfläche 6a und 6b für den Transport geschützt ist.

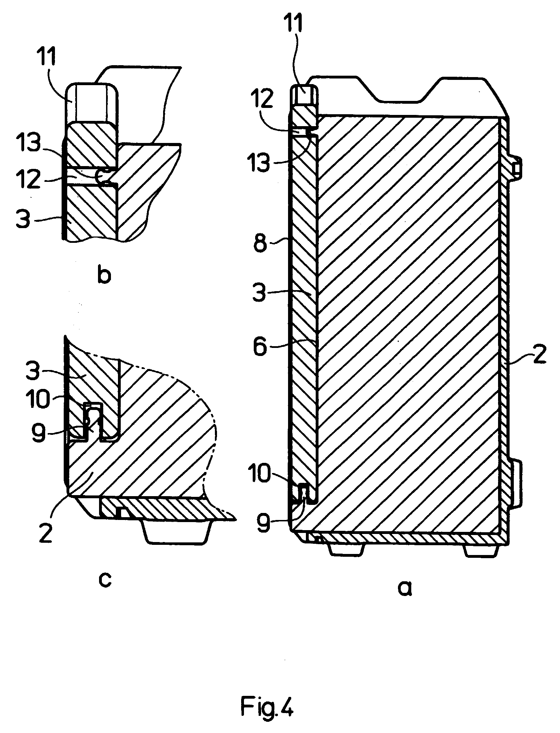

Aus der Figur 4 ist die Anordnung und Fixierung der Benutzerschnittstelle 3 an dem Gehäusekasten 2 ersichtlich. Figur 4a zeigt einen schematischen Querschnitt durch das gesamte Messgerät, wobei die im Inneren des Gehäusekastens 2 sich befindlichen Komponenten des Messgerätes aus Vereinfachungsgründen nicht dargestellt sind. Wie bereits erwähnt, ist die Benutzerschnittstelle 3 in einer Ausnehmung 5 im Gehäusekasten 2 fixierbar, so dass die Außenkontur der Schnittstelle 3 die Außenkontur des Gehäusekastens 2 nicht überragt und harmonisch und für den Transport nicht störend und geschützt fixiert ist. Hierzu befinden sich an dem Gehäusekasten 2 in der Ausnehmung 5 zwei Stifte 9, die in entsprechenden Ausnehmungen 10 der Benutzerschnittstelle 3 eingreifen. Diese Fixierung ist in der Figur 4c noch einmal vergrößert dargestellt. Zur weiteren Fixierung der Benutzerschnittstelle 3 sind im oberen Bereich in der Nähe des Griffes 11 weitere Bohrungen 12 vorgesehen, in die Stifte 13 eingreifen, um rastend die Benutzerschnittstelle 3 zu halten. Diese Fixierung ist ebenfalls vergrößert in der Figur 4b dargestellt.

Grundsätzlich kann die Fixierung auch durch ein Klettband oder andere geeignete Befestigungsmittel realisiert werden.

## Patentansprüche

1. Mobiles elektrisches Messgerät mit einem Gehäusekasten zur Aufnahme im Inneren der für den Betrieb des Messgeräts erforderlichen Gerätekomponenten und mit einer Benutzerschnittstelle zur Bedienung des Messgeräts, **gekennzeichnet durch,** eine separate vom Gehäusekasten abnehmbare Bedienungseinheit (3) als Benutzerschnittstelle mittels der das Messgerät (1) entfernt von dem Gehäusekasten (2) benutzbar ist, wobei die Bedienungseinheit (3) Bedienelemente zur Bedienung des Messgeräts zur Durchführung von Messungen und/oder Messauswertungen sowie Anzeigeelemente zur Darstellung von Messergebnissen und/oder Messergebnisauswertungen aufweist.

2. Elektrisches Messgerät nach Anspruch 1, **dadurch gekennzeichnet**, dass die Bedienungseinheit (3) als ein Flachmodul mit Flachbildschirm ausgebildet ist, das auf einer Flachseite eine großflächige Anzeige (6a, 6b) mit integrierten oder separaten Bedienelementen aufweist.

3. Elektrisches Messgerät nach Anspruch 1 oder 2, **dadurch gekennzeichnet,** dass der Gehäusekasten (2) Halteelemente (9, 10; 12, 13) zum Fixieren der Bedienungseinheit am Gehäusekasten (2) aufweist.

4. Elektrisches Messgerät nach einem der vorangegangenen Ansprüche, **dadurch gekennzeichnet,** dass die Bedienungseinheit (3) mit der Vorderseite (6) oder der Rückseite (8) dem Gehäusekasten (2) zugewandt an diesem fixierbar ist.

5. Elektrisches Messgerät nach einem der vorangegangenen Ansprüche, **dadurch gekennzeichnet,** dass die Bedienungseinheit (3) in einer Ausnehmung (5) in dem Gehäusekasten (2) integrierbar ist.

6. Elektrisches Messgerät nach Anspruch 5, **dadurch gekennzeichnet,** dass die Bedienungseinheit in der Ausnehmung (5) mit ihrer Außenkontur die Außenkontur des Gehäusekastens (2) nicht überragt.

7. Verwendung eines Gehäusekastens (2) mit einer separaten vom Gehäusekasten abnehmbaren Bedienungseinheit (3) für die im Inneren des Gehäusekastens (2) angeordneten Gerätekomponenten als nicht stationäres elektrisches Messgerät zur Durchführung von über die Bedienungseinheit (3) entfernt von dem Gehäusekasten (2) ausgelösten Messungen sowie Darstellungen von Messergebnissen und/oder Messergebnisauswertungen.
